# EUROPEAN PATENT APPLICATION

(11) **EP 4 823 254 A1**
(43) Date of publication of application: **14.10.2026**
(21) Application number: 24899735.5
(22) Date of filing: 29.11.2024
(51) Int. Cl.: H05K 7/20

(54) **HEAT DISSIPATION DEVICE FOR MARX GENERATOR, AND MARX GENERATOR**

(30) Priority: 04.12.2023 CN 202311649365
(71) Applicant: Nuctech Company Limited, TongFang Building, Shuangqinglu, Haidian District Beijing 100084 (CN); Tsinghua University, Haidian District, Beijing 100084 (CN)
(72) Inventor: ZHANG, Liang, Beijing 100084 (CN); LIU, Yaohong, Beijing 100084 (CN); LIU, Jinsheng, Beijing 100084 (CN); CHEN, Huaibi, Beijing 100084 (CN); TANG, Chuanxiang, Beijing 100084 (CN)
(74) Representative: Cabinet Beau de Loménie
(86) International application number: PCT/CN2024/135628
(87) International publication number: WO 2025/119095

(57) **Abstract**

Provided is a heat dissipation device for a Marx generator. The device comprises N cooling plates arranged in sequence; a switch assembly of a Marx generator is fixed on each cooling plate, and the switch assemblies on the N cooling plates are sequentially connected in series; each cooling plate has a water inlet and a water outlet, cooling water flows into the cooling plate from the water inlet and flows out from the water outlet, and the water inlets and water outlets of different cooling plates are connected by means of water cooling lines to achieve the flow of the cooling water across the cooling plates; the cooling water flows in from the water inlet of the first cooling plate, flows out from the water outlet of the first cooling plate, sequentially passes through m cooling plates except the second cooling plate, then flows into the water inlet of an N-th cooling plate, flows out from the water outlet of the N-th cooling plate, sequentially flows through k cooling plates, and then flows out from the water outlet of the second cooling plate, wherein m+k=N-3, 0 ≤ m ≤ N-3, 0 ≤ k≤ N-3, and the m cooling plates and the k cooling plates are different from each other.

## Description

### TECHNICAL FIELD

The present disclosure relates to the field of heat dissipating technologies, and in particular to a heat dissipating device for a Marx generator and a Marx generator.

### BACKGROUND

A main function of a pulse high-voltage modulator is to generate a pulse high voltage to supply power to a magnetron, so as to generate a microwave required by an accelerating tube. A switch module is a core component of the pulse high-voltage modulator, used to form the pulse high voltage by controlling a discharge of an energy storage element.

The switch module includes a Marx pulse generator, the Marx generator includes a plurality of series-connected switch components to form a high-voltage switch combination, which may generate a high-voltage pulse circuit by charging capacitors in groups and then discharging the capacitors. Due to an internal resistance of the switch component, when a large charging and discharging current flows through a body thereof for a long time, heat may be accumulated, which may cause the switch component to overheat. If the heat inside the switch component may not be conducted and dissipated in time, when a temperature exceeds a normal working effective range of the switch component, the switch component may be burned out. Therefore, an effective heat dissipating of the switch component is currently required.

However, since the switch component may generate a large voltage during discharging, a high voltage difference may lead to a problem of high-voltage hazard during heat dissipating.

The above-mentioned information disclosed in the section is only used to understand the background of the inventive concept of the present disclosure. Therefore, the above-mentioned information may include information that does not constitute the prior art.

### SUMMARY

In view of at least one aspect of the above-mentioned technical problems, the present disclosure provides a heat dissipating device for a Marx generator and a Marx generator.

According to a first aspect of the present disclosure, a heat dissipating device for a Marx generator is provided, the device including N cooling plates arranged in sequence. A switch component of the Marx generator is fixed on each of the N cooling plates, and the switch components on the N cooling plates are connected in series in sequence; each of the N cooling plates is provided with a water inlet and a water outlet, cooling water flows from the water inlet into an interior of the cooling plate and flows out of the water outlet, and the water inlets and the water outlets of different cooling plates are connected by water cooling connection lines to allow the cooling water to flow across the cooling plates. The cooling water flows in through the water inlet of a first cooling plate and flows out of the water outlet of the first cooling plate, after sequentially flowing through m cooling plates other than a second cooling plate, the cooling water flows into the water inlet of an N^{th} cooling plate and flows out of the water outlet of the N^{th} cooling plate, after sequentially flowing through k cooling plates, the cooling water flows out of the water outlet of the second cooling plate, where m+k=N-3, 0≤m≤N-3, and 0≤k≤N-3, and the m cooling plates are different from the k cooling plates.

According to the embodiments of the present disclosure, the water cooling connection lines connect the first cooling plate and the m cooling plates successively according to a first connection rule that the water outlet of the (1+a×p)^{th} cooling plate is connected to the water inlet of the (1+(a+1)p)^{th} cooling plate, and the water outlet of the (1+m×p)^{th} cooling plate is connected to the water inlet of the N^{th} cooling plate, where a∈[0, m-1], p is an integer greater than 1, m≥1, and 1+m×p<N.

According to the embodiments of the present disclosure, 1≤N-(1+m×p)≤p.

According to the embodiments of the present disclosure, 2≤p≤4.

According to the embodiments of the present disclosure, the value of p is 2.

According to the embodiments of the present disclosure, N is an odd number, and N-(1+m×p)=2.

According to the embodiments of the present disclosure, N is an even number, and N-(1+m×p)=1.

According to the embodiments of the present disclosure, the water cooling connection lines connect the N^{th} cooling plate and the k cooling plates successively according to a second connection rule that, the water outlet of the (N-b×q)^{th} cooling plate is connected to the water inlet of the (N-(b+1)×q)^{th} cooling plate, and the water outlet of the (N-k×q)^{th} cooling plate is connected to the water inlet of the second cooling plate, where b∈[0,k-1], q is an integer greater than 1, k≥1, and N-k×q>2.

According to the embodiments of the present disclosure, 1≤(N-k×q)-2≤q.

According to the embodiments of the present disclosure, 2≤q≤4.

According to the embodiments of the present disclosure, each of the N cooling plates includes a first surface and a second surface opposite each other, and the switch component is located on the first surface and is in metallic contact with the first surface.

According to the embodiments of the present disclosure, the N cooling plates are arranged in sequence in a first direction, the water inlet and the water outlet are disposed on a side surface of each of the N cooling plates, and the water inlets and the water outlets corresponding to the N cooling plates are alternately arranged in the first direction.

According to the embodiments of the present disclosure, the switch component of the Marx generator includes: an IGBT; a Zener diode, an input end of the Zener diode is electrically connected to a first end of the IGBT; a capacitor connected in series between a second end of the IGBT and an output end of the Zener diode; and an input diode electrically connected to the first end of the IGBT.

According to a second aspect of the present disclosure, a Marx generator is provided, including the heat dissipating device described above.

After flowing out of the first cooling plate, the cooling water sequentially flows through the m cooling plates and finally flows to the N cooling plate. A voltage difference of N units may be accumulated due to the influence of the voltage generated by the discharging of the switch components. After that, the cooling water flows out of the N^{th} cooling plate, and after sequentially flowing through the k cooling plates, the cooling water flows back to the second cooling plate to flow out. During the backflow process, the accumulated voltage difference of N units may be cancelled out, so that a final voltage difference between the water outlet of the second cooling plate and the water inlet of the first cooling plate is only a voltage difference of 2 units. Moreover, since m+k=N-3, that is, when the cooling water flows through each cooling plate, a heat dissipating of each switch component may be realized. At the same time, compared to the case that the cooling water flows in through the first cooling plate and finally flows out of the N^{th} cooling plate, the voltage of the cooling water may be greatly reduced, thereby greatly reducing the high-voltage hazard.

### BRIEF DESCRIPTION OF THE DRAWINGS

In order to better understand the present disclosure, the present disclosure will be described below in detail with reference to the accompanying drawings, in which:
FIG. 1 is a structural block diagram of a conventional pulse high-voltage modulator;
FIG. 2 is a schematic structural diagram of a conventional Marx generator;
FIG. 3 is an enlarged diagram of a structure in a dashed box in FIG. 2;
FIG. 4 is a schematic structural diagram of a conventional heat dissipating device for a Marx generator;
FIG. 5 is a schematic structural diagram of another conventional heat dissipating device for a Marx generator;
FIG. 6 is an enlarged diagram of a partial structure in a heat dissipating device for a Marx generator according to embodiments of the present disclosure;
FIG. 7 is a schematic connection diagram of water cooling connection lines of a heat dissipating device for a Marx generator according to some exemplary embodiments of the present disclosure;
FIG. 8 is a schematic connection diagram of water cooling connection lines of a heat dissipating device for a Marx generator according to other exemplary embodiments of the present disclosure;
FIG. 9 schematically shows a schematic diagram of connecting water cooling connection lines of a heat dissipating device for a Marx generator according to the embodiments of the present disclosure based on a first connection rule;
FIG. 10 schematically shows a specific schematic connection diagram of connecting water cooling connection lines of a heat dissipating device for a Marx generator according to the embodiments of the present disclosure based on a first connection rule;
FIG. 11 schematically shows another specific schematic connection diagram of connecting water cooling connection lines of a heat dissipating device for a Marx generator according to the embodiments of the present disclosure based on a first connection rule;
FIG. 12 schematically shows yet another specific schematic connection diagram of connecting water cooling connection lines of a heat dissipating device for a Marx generator according to the embodiments of the present disclosure based on a first connection rule;
FIG. 13 schematically shows still another specific schematic connection diagram of connecting water cooling connection lines of a heat dissipating device for a Marx generator according to the embodiments of the present disclosure based on a first connection rule;
FIG. 14 schematically shows a schematic diagram of connecting water cooling connection lines of a heat dissipating device for a Marx generator according to the embodiments of the present disclosure based on a second connection rule; and
FIG. 15 is a schematic connection diagram of water cooling connection lines of a heat dissipating device for a Marx generator according to still other exemplary embodiments of the present disclosure.

### DETAILED DESCRIPTION OF EMBODIMENTS

Specific embodiments of the present disclosure will be described below in detail. It should be noted that the embodiments described here are only for illustration and are not intended to limit the present disclosure. In the following descriptions, in order to provide a thorough understanding of the present disclosure, a large number of specific details are described. However, it is obvious to those skilled in the art that these specific details are not necessary for implementing the present disclosure. In other examples, in order to avoid confusion of the present disclosure, well-known structures, materials or methods are not specifically described.

In the entire specification, reference to "an embodiment", "embodiments", "an example" or "examples" means that specific features, structures or characteristics described in combination with the embodiment(s) or example(s) are included in at least one embodiment of the present disclosure. Therefore, terms "in an embodiment", "in embodiments", "an example" or " examples" described in the entire specification do not necessarily refer to one and same embodiment or example. In addition, the specific features, structures or characteristics may be combined in one or more embodiments or examples in any suitable combination and/or subcombination. In addition, those skilled in the art should understand that a term "and/or" used here includes any and all combinations of one or more related listed items.

Terms used here are only intended to describe specific embodiments and are not intended to limit the present disclosure. Terms "include", "comprise", etc., used here indicate the presence of the described features, steps, operations and/or components, but do not exclude the presence or addition of one or more other features, steps, operations and/or components.

All terms (including technical and scientific terms) used here have meanings generally understood by those of ordinary skill in the art, unless otherwise defined. It should be noted that the terms used here should be interpreted as having the meaning consistent with the context of the present disclosure, and should not be interpreted in an idealized or overly rigid manner.

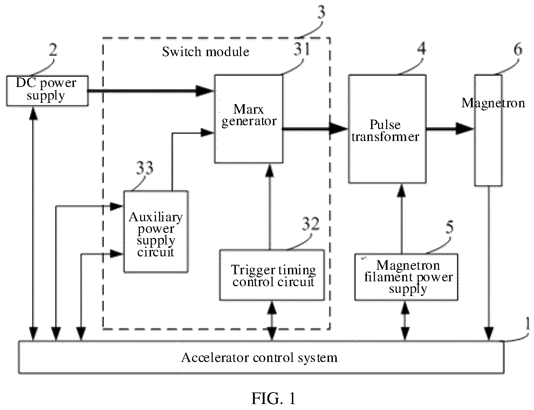

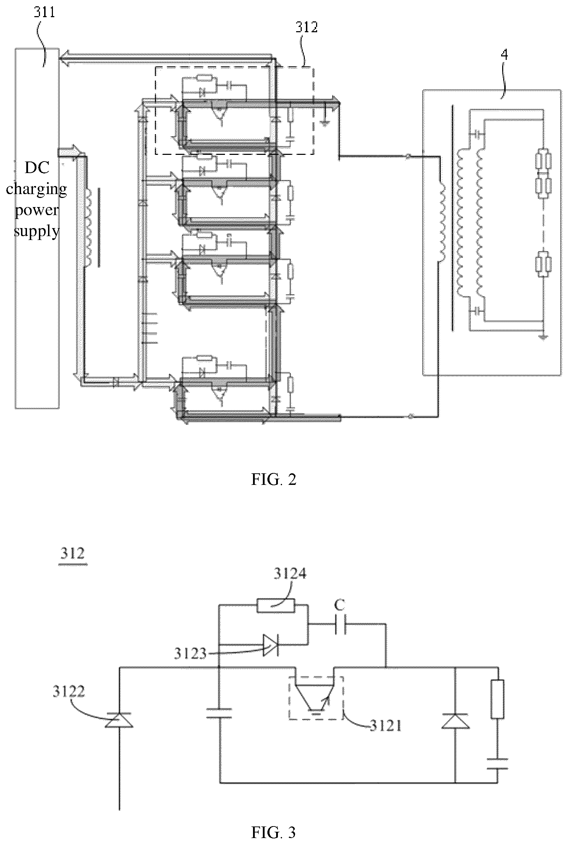

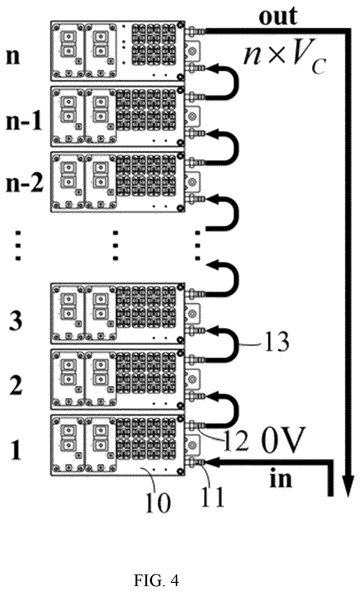

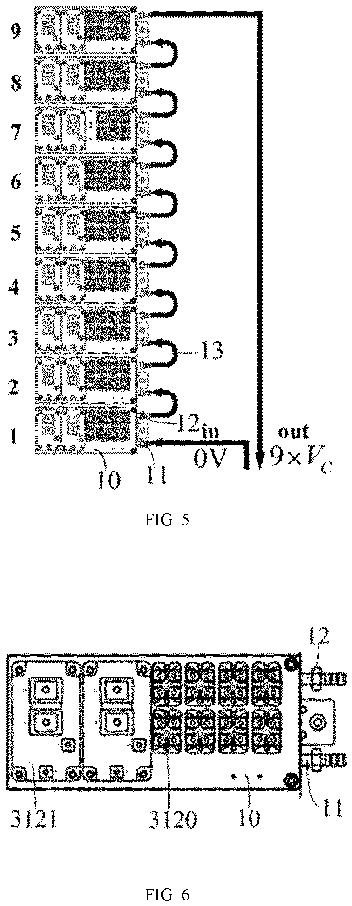

FIG. 1 is a structural block diagram of a conventional pulse high-voltage modulator; FIG. 2 is a schematic structural diagram of a conventional Marx generator; FIG. 3 is an enlarged diagram of a structure in a dashed box in FIG. 2; FIG. 4 is a schematic structural diagram of a conventional heat dissipating device for a Marx generator; and FIG. 5 is a schematic structural diagram of another conventional heat dissipating device for a Marx generator.

A main function of a pulse high-voltage modulator is to generate a pulse high voltage to supply power to a magnetron, so as to generate a microwave required by an accelerating tube. As shown in FIG. 1, a pulse high-voltage modulator may include: an accelerator control system 1, a DC power supply 2, a switch module 3, a pulse transformer 4, a magnetron filament power supply 5 and a magnetron 6.

Under the control of the accelerator control system 1, the DC power supply 2 rectifies and inverts an urban power to generate a DC power of 700V for example, to supply power to the switch module 3.

The switch module 3 is a core component of the pulse high-voltage modulator. The switch module 3 mainly includes a Marx generator 31, a trigger timing control circuit 32 and an auxiliary power supply circuit 33.

After the Marx generator 31 in the switch module 3 is charged, the pulse transformer 4 is discharged under the control of the trigger timing control unit 32. A DC output of the DC power supply 2 is converted into a pulse power, which is provided to the pulse transformer 4 for boosting so as to generate the pulse high voltage, thereby supplying power to the magnetron 6.

The Marx generator 31 is a way to realize a pulse modulation power supply, which is a device that uses capacitors to charge in parallel and then discharge in series. The Marx generator 31 may realize a nanosecond-level narrow pulse and an extremely high pulse frequency.

As shown in FIG. 2, the Marx generator may include: a DC charging power supply 311 and a plurality of switch components 312 connected in series. The DC charging power supply 311 is a power supply, and each switch component 312 is used to generate a high-voltage pulse circuit by charging and discharging. The number of the switch components 312 may be set according to a required pulse voltage.

Specifically, referring to FIG. 3, in some embodiments, the switch component 312 of the Marx generator may include: an IGBT (insulated gate bipolar transistor) 3121; a Zener diode 3123, where an input end of the Zener diode 3123 is electrically connected to a first end of the IGBT; a capacitor C connected in series between a second end of the IGBT 3121 and an output end of Zener diode 3123; and an input diode 3122 electrically connected to the first end of the IGBT 3121.

Specifically, a gate electrode of the IGBT 3121 is connected to a drive circuit (not shown) to be turned on or off according to a driving signal from the drive circuit.

A first end of the capacitor C is connected to a collector of the IGBT 3121, and a second end of the capacitor C is connected to the output end of the Zener diode 3123 so as to be connected to an emitter of the IGBT 3121 through the Zener diode 3123.

In some embodiments, the switch component 312 further includes a resistor 3124 connected in series with the Zener diode 3123. Each of the resistor 3124 and the Zener diode 3123 has a function of voltage stabilization, thus may provide a stable voltage to the emitter of the IGBT 3121.

The IGBT 3121 is used for pulse modulation. Specifically, a DC charging power supply charges the capacitor C through a charging inductor and the input diode 3122 of each switch component 312, thereby forming a capacitor array charged in parallel and forming a charging loop. The charging loop is shown by a light gray arrow in FIG. 2.

When a discharge trigger arrives, each IGBT 3121 is turned on, and the capacitors on the switch components 312 form a series-connected discharge loop through the IGBTs 3121, as shown by a dark gray arrow in FIG. 2. A voltage generated by a discharge of each switch component is 1V_{c}. For n switch components, a voltage generated by a discharge is nV_{c}.

Heat may be accumulated in the Zener diode 3123, the input diode 3122 and the IGBT 3121 during a charging and discharging process. In order to dissipate heat from the switch component 312, a conventional method is to add a large-volume tooth-grooved heat sink for the switch component, so as to dissipate heat from the switch component through conductive heat dissipation.

However, the inventors have found that high-power heat sinks may suffer from drawbacks such as complex structure, large size, inflexible installation, and high cost, which may restrict the practical application of the switch component. When the switch component is cooled by water cooling heat dissipating, a cooling effect may be better, a noise during working may be lower, and a structure of the switch component may be more compact, so that a miniaturization of the switch component may be realized.

The inventors have also found that, water cooling the switch component of the Marx generator by using the method shown in FIG. 5 provides good water-cooling heat dissipating effect. However, there is a problem of a voltage difference between the water inlet end of the cooling water and the water outlet end out of which the cooling water finally flows, which may lead to a high-voltage hazard and could accidentally injure personnel.

Specifically, referring to FIG. 5, the number of cooling plates 10 is nine, and each cooling plate 10 is provided with a water inlet 11 and a water outlet 12. A flow of the cooling water inside the cooling plate 10 may be realized through the water inlet 11 and a water outlet 12.

The water cooling connection lines 13 connect the water inlets 11 and the water outlets 12 of the cooling plates in sequence from a first cooling plate to a ninth cooling plate, so as to allow the cooling water to flow across the cooling plates. The cooling water may flow through nine cooling plates in sequence to flow out of the water outlet of the ninth cooling plate.

The switch component of the Marx generator is located on the cooling plate 10, and the switch components on different cooling plates 10 are connected in series. When the discharge trigger arrives, each IGBT is turned on, and the capacitors on the switch components form a series-connected discharge loop through the IGBTs, each switch component generates a voltage of 1V_{c}, and a whole series-connected loop generates a voltage of 9V_{c}.

Since the cooling plate 10 and the switch component are equipotential, each cooling plate also generates a voltage of 1V_{c}. Therefore, the voltage at the water inlet of the first cooling plate is 0V_{c}, and the voltage at the water outlet of the first cooling plate is 1V_{c}. A voltage difference of 2V_{c} is provided between the water inlet 11 of the first cooling plate and the water outlet 12 of the second cooling plate, and a voltage difference of 9V_{c} is provided between the water inlet 11 of the first cooling plate and the water outlet 12 of the ninth cooling plate. In this way, a voltage difference of 9V_{c} may be provided between a water inlet end and a final water outlet end when water cooling heat dissipating is performed using the method as shown in FIG. 5.

It may be understood that, taking only nine cooling plates as an example in FIG. 5, if the number of cooling plates 10 is n (referring to FIG. 4), a voltage difference of nV_{c} may be provided between the water inlet end and the final water outlet end. If n is large enough, the voltage difference may be as high as a level of 10 kV. Since an internal resistance of the cooling water is about 1 kΩ, the current in the cooling water is about 120 A, which may cause a high-voltage danger and easily cause harm to the human body.

In view of this, the embodiments of the present disclosure provide a heat dissipating device for a Marx generator. The heat dissipating device may include N cooling plates. After flowing out of the first cooling plate, the cooling water passes m cooling plates in sequence, and after flowing to an N^{th} cooling plate, passes through k cooling plates 10 in sequence, and finally flows back to the second cooling plate to flow out. The backflow process may cancel out most of a voltage difference of N units generated by the cooling water flowing through the first cooling plate and the m cooling plates to the N cooling plates 10, so that a final voltage of the cooling water is only a voltage difference between the water outlet of the second cooling plate and the water inlet of the first cooling plate, that is, only two voltage differences, which may greatly reduce a voltage of the cooling water. Since m+k=N-3, that is, when the cooling water flows through each cooling plate, heat dissipating of each switch component may be realized, thereby realizing an effective heat dissipating of each cooling plate and greatly reducing a high-voltage hazard.

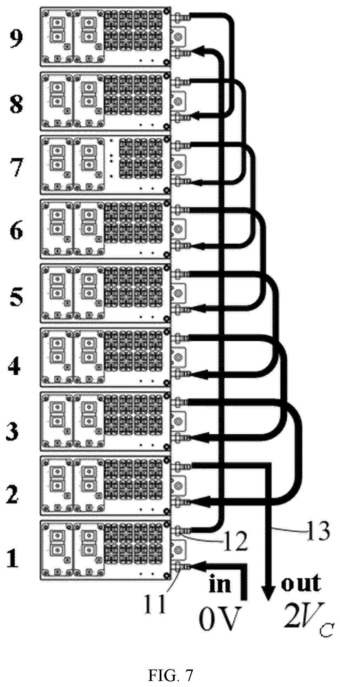

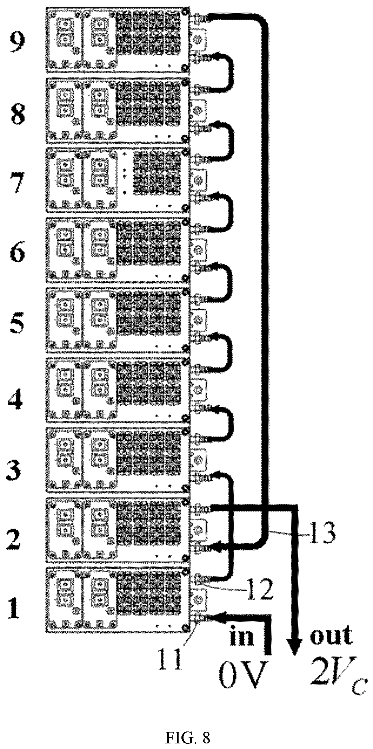

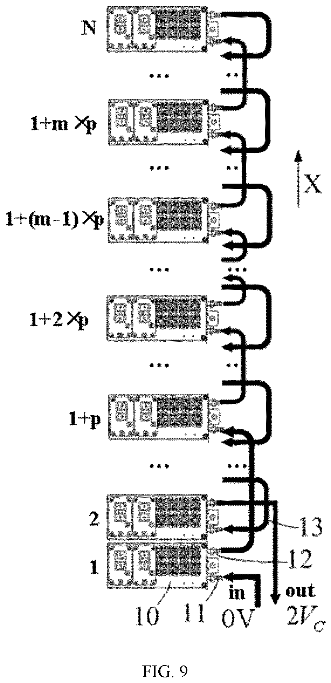

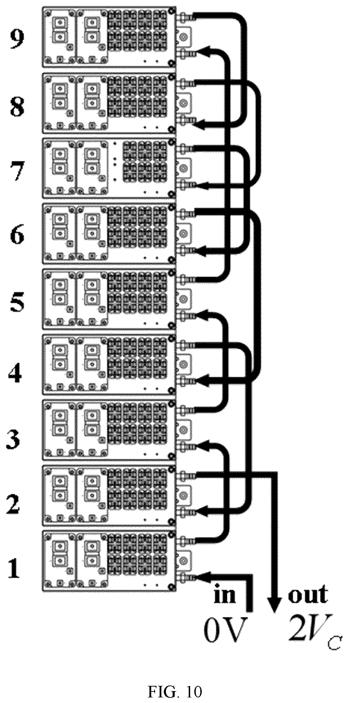

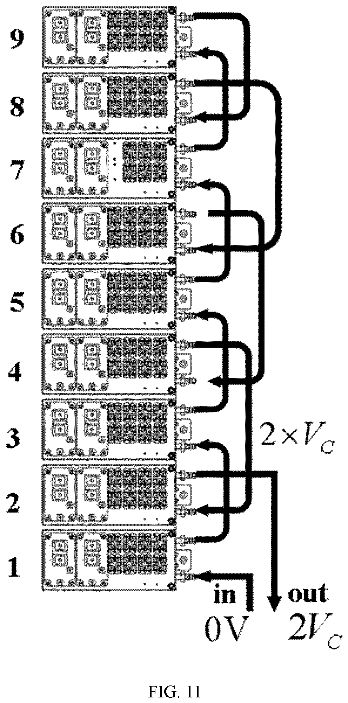

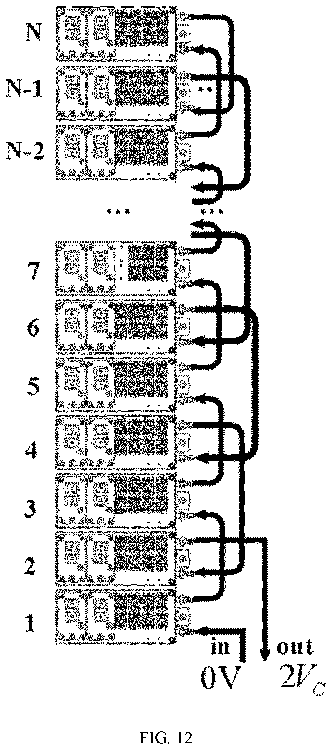

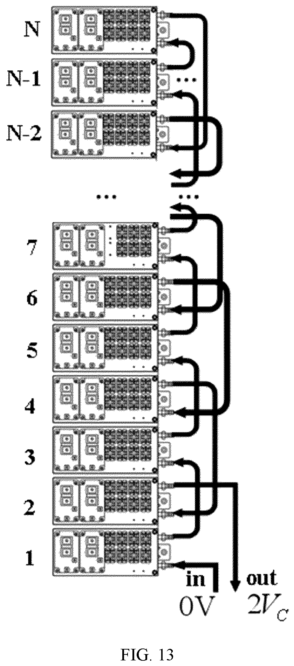

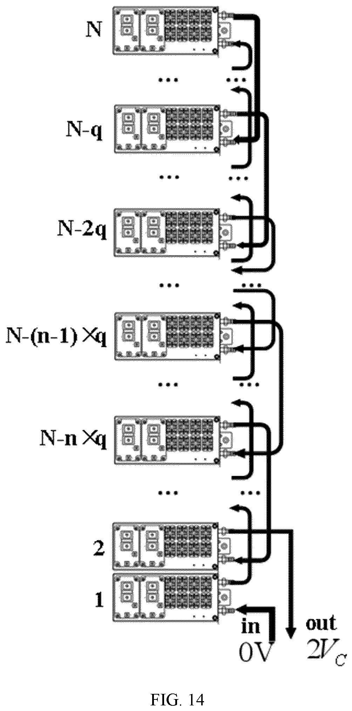

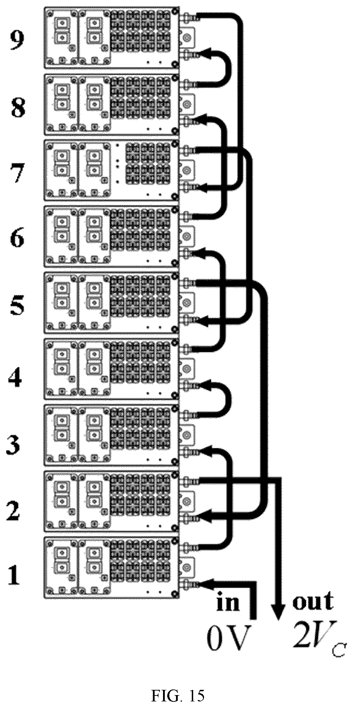

FIG. 6 is an enlarged diagram of a partial structure in a heat dissipating device for a Marx generator according to embodiments of the present disclosure; FIG. 7 is a schematic connection diagram of water cooling connection lines of a heat dissipating device for a Marx generator according to some exemplary embodiments of the present disclosure; FIG. 8 is a schematic connection diagram of water cooling connection lines of a heat dissipating device for a Marx generator according to other exemplary embodiments of the present disclosure; FIG. 9 schematically shows a schematic diagram of connecting water cooling connection lines of a heat dissipating device for a Marx generator according to the embodiments of the present disclosure based on a first connection rule; FIG. 10 schematically shows a specific schematic connection diagram of connecting water cooling connection lines of a heat dissipating device for a Marx generator according to the embodiments of the present disclosure based on a first connection rule; FIG. 11 schematically shows another specific schematic connection diagram of connecting water cooling connection lines of a heat dissipating device for a Marx generator according to the embodiments of the present disclosure based on a first connection rule; FIG. 12 schematically shows yet another specific schematic connection diagram of connecting water cooling connection lines of a heat dissipating device for a Marx generator according to the embodiments of the present disclosure based on a first connection rule; FIG. 13 schematically shows still another specific schematic connection diagram of connecting water cooling connection lines of a heat dissipating device for a Marx generator according to the embodiments of the present disclosure based on a first connection rule; FIG. 14 schematically shows a schematic diagram of connecting water cooling connection lines of a heat dissipating device for a Marx generator according to the embodiments of the present disclosure based on a second connection rule; and FIG. 15 is a schematic connection diagram of water cooling connection lines of a heat dissipating device for a Marx generator according to still other exemplary embodiments of the present disclosure.

Referring to FIG. 6 to FIG. 15, the heat dissipating device for a Marx generator may include: N cooling plates 10 arranged in sequence, where a switch component of the Marx generator is fixed on each cooling plate 10, and the switch components located on the N cooling plates 10 are connected in series in sequence; each cooling plate 10 is provided with a water inlet 11 and a water outlet 12, cooling water flows from the water inlet 11 into an interior of the cooling plate 10 and flows out of the water outlet 12, and the water inlets 11 and the water outlets 12 of different cooling plates 10 are connected by a water cooling connection line, so as to allow the cooling water to flow across the cooling plates 10. The cooling water flows in through the water inlet 11 of the first cooling plate and flows out of the water outlet 12 of the first cooling plate, after passing through m cooling plates in sequence other than a second cooling plate, the cooling water flows into the water inlet 11 of an N^{th} cooling plate and out of the water outlet 12 of the N^{th} cooling plate. After flowing through k cooling plates in sequence, the cooling water flows out of the water outlet 12 of the second cooling plate, where m+k=N-3, 0≤m≤N-3, and 0≤k≤N-3, and the m cooling plates are different from the k cooling plates.

In some embodiments, the cooling plate 10 includes a first surface and a second surface opposite each other, and the switch component is located on the first surface and is in metallic contact with the first surface.

In some embodiments, the metallic contact may be any one of a bolt connection, a rivet connection or welding.

In a specific embodiment, the cooling plate 10 is made of metal, and the cooling plate 10 is fixedly connected to the switch component by a bolt.

Referring to FIG. 3, in some embodiments, the switch component of the Marx generator includes: an IGBT 3121; a Zener diode 3123, where an input end of the Zener diode 3123 is electrically connected to a first end of the IGBT 3121; a capacitor C connected in series between a second end of the IGBT 3121 and an output end of the Zener diode 3123; and an input diode 3122 electrically connected to the first end of the IGBT 3121.

A gate electrode of the IGBT 3121 is connected to a drive circuit (not shown) to be turned on or off according to a driving signal from the drive circuit.

A first end of the capacitor C is connected to a collector of the IGBT 3121, and a second end of the capacitor C is connected to the output end of the Zener diode 3123 so as to be connected to an emitter of the IGBT 3121 through the Zener diode 3123.

In some embodiments, the switch component further includes a resistor connected in series with the Zener diode 3123. Each of the resistor and the Zener diode 3123 has a function of voltage stabilization, thus may provide a stable voltage to the emitter of the IGBT 3121.

The IGBT 3121 is used for pulse modulation. Specifically, a DC charging power supply charges the capacitor C through a charging inductor and the input diode 3122 of each switch component, thereby forming an array of capacitors C charged in parallel.

When a discharge trigger arrives, each IGBT 3121 is turned on, and the capacitors C on the switch components form a series-connected discharge loop through the IGBTs 3121. A voltage generated by a discharge of each switch component is 1V_{c}. For N switch components, a voltage generated by a discharge is NV_{c}.

As shown in FIG. 6, in the switch component located on the first surface of the cooling plate 10, the number of IGBTs 3121 may be two, and the number of diodes 3120 may be eight. The diodes 3120 include the input diode 3122 and the Zener diode 3123.

Since the cooling plate 10 is made of metal and is in metallic contact with the switch component, the cooling plate 10 and the switch component are equipotential. A voltage on the cooling plate 10 is consistent with a voltage generated by the switch component. When the cooling water flows inside the cooling plate 10, a voltage generated by a cooling plate may be accumulated every time it flows through a cooling plate. After the cooling water flows from the first cooling plate to the N^{th} cooling plate, a voltage generated by the N cooling plates 10 may be generated by accumulation.

When the cooling water flows back from the N^{th} cooling plate towards the first cooling plate, since a flow direction is opposite, an accumulated voltage may have an opposite voltage drop direction. For example, the accumulated voltage of the cooling water flowing from the first cooling plate to the N^{th} cooling plate may be a positive voltage, and an accumulated voltage flowing from the N^{th} cooling plate towards the first cooling plate may be a negative voltage. The positive voltage and the negative voltage cancel each other out. Therefore, the accumulated voltage of the cooling water flowing back from the N^{th} cooling plate towards the first cooling plate may cancel out the accumulated voltage of the cooling water flowing from the first cooling plate to the N^{th} cooling plate, and a final voltage is only a voltage difference between the water outlet 12 of the second cooling plate and the water inlet 11 of the first cooling plate.

If a voltage generated by a switch component is 1V_{c}, a final voltage of the cooling water is only a voltage of two cooling plates, that is, 2V_{c}.

Referring to FIG. 9, in some embodiments, the N cooling plates 10 are arranged in sequence in a first direction X, the water inlet 11 and the water outlet 12 are disposed on a side surface of the cooling plate 10, and the water inlets 11 and the water outlets 12 corresponding to the N cooling plates 10 are alternately arranged in the first direction X.

A cooling water circulation pipeline is provided inside the cooling plate 10, with two ends of the cooling water circulation pipeline in communication with the water inlet 11 and the water outlet 12, respectively. The cooling water flows in the cooling water circulation pipeline to take away the heat generated by the switch component.

In some embodiments, the second surface may be coated with a thermal conductive silicone grease. The thermal conductive silicone grease has good thermal conductivity and may further dissipate the heat generated by the switch component.

It is readily apparent that the m cooling plates 10 and the k cooling plates 10 are the cooling plates 10 among the N cooling plates 10 other than the first cooling plate, the second cooling plate and the N^{th} cooling plate, and the m cooling plates are different from the k cooling plates 10. That is, the cooling water flows in through the first cooling plate and flows through the N cooling plates 10 before finally flowing out of the second cooling plate, so that the N cooling plates 10 may be cooled.

The value of N may be determined according to a numerical value of switch components, and each cooling plate 10 is used to cool and dissipate heat from a switch component. The number of switch components may be set according to a required pulse voltage. The value of N will not be specifically limited in the embodiments of the present disclosure.

In some embodiments, if the value of m is 0, the k cooling plates 10 are the remaining cooling plates 10 other than the first cooling plate, the second cooling plate and the N^{th} cooling plate. That is, the water cooling connection line connects the water outlet 12 of the first cooling plate to the water inlet 11 of the N^{th} cooling plate. After flowing out of the water outlet 12 of the first cooling plate, the cooling water flows directly into the water inlet 11 of the N^{th} cooling plate via the water cooling connection line. The water cooling connection line is connected to the N^{th} cooling plate, the k cooling plates 10 and the second cooling plate successively.

Specifically, the above-mentioned connection method will be described by taking nine cooling plates 10 as an example. When m is 0, k is 6. The k cooling plates 10 are an eighth cooling plate to a third cooling plate, respectively.

Referring to FIG. 7, the water inlet 11 of the first cooling plate is connected to a water cooling connection line, and the cooling water flows into the water inlet 11 of the first cooling plate from the water cooling connection line. The water outlet 12 of the first cooling plate is connected to the water inlet 11 of the ninth cooling plate through the water cooling connection line. The water outlet 12 of the ninth cooling plate is connected to the water inlet 11 of the eighth cooling plate through the water cooling connection line, the water outlet 12 of the eighth cooling plate is connected to the water inlet 11 of a seventh cooling plate through the water cooling connection line, and so on, until the water outlet 12 of a fourth cooling plate is connected to the water inlet 11 of a third cooling plate through the water cooling connection line. Finally, the water outlet 12 of the third cooling plate is connected to the water inlet 11 of the second cooling plate through the water cooling connection line. The water outlet 12 of the second cooling plate is connected to a water cooling connection line, and the cooling water finally flows out of the water outlet 12 of the second cooling plate through the water cooling connection line.

In some embodiments, when the value of k is 0, the m cooling plates are the remaining cooling plates 10 other than the first cooling plate, the second cooling plate and the N^{th} cooling plate. That is to say, the water cooling connection line connects the water outlet of the first cooling plate to the water inlet of the third cooling plate, connects the water outlet of the third cooling plate to the water inlet of the fourth cooling plate, and so on, until the water inlet of the N^{th} cooling plate is connected. The water outlet of the N^{th} cooling plate is directly connected to the water inlet of the second cooling plate through the water cooling connection line. The water outlet of the second cooling plate is connected to a water cooling connection line, and the cooling water finally flows out of the water outlet of the second cooling plate through the water cooling connection line.

As shown in FIG. 8, when the number of cooling plates 10 is nine, and k is 0, m is 6. The water inlet 11 of the first cooling plate is connected to a water cooling connection line, and the cooling water flows into the water inlet 11 of the first cooling plate from the water cooling connection line. The water outlet 12 of the first cooling plate is connected to the water inlet 11 of the third cooling plate through the water cooling connection line. The water outlet 12 of the third cooling plate is connected to the water inlet 11 of the fourth cooling plate through the water cooling connection line. The water outlet 12 of the fourth cooling plate is connected to the water inlet 11 of a fifth cooling plate through the water cooling connection line. The water outlet 12 of the fifth cooling plate is connected to the water inlet 11 of a sixth cooling plate through the water cooling connection line. The water outlet 12 of the sixth cooling plate is connected to the water inlet 11 of a seventh cooling plate through the water cooling connection line. The water outlet 12 of the seventh cooling plate is connected to the water inlet 11 of an eighth cooling plate through the water cooling connection line. The water outlet 12 of the eighth cooling plate is connected to the water inlet 11 of a ninth cooling plate through the water cooling connection line. The water outlet 12 of the ninth cooling plate is connected to the water inlet 11 of the second cooling plate through the water cooling connection line. The water outlet 12 of the second cooling plate is connected to a water cooling connection line, and the cooling water finally flows out of the water outlet 12 of the second cooling plate through the water cooling connection line.

In some embodiments, 0<m<N-3 and 0<k<N-3. That is to say, both m and k are not 0. The first cooling plate is not directly connected to the N^{th} cooling plate, and the N^{th} cooling plate is not directly connected to the second cooling plate. In this way, on one hand, the length of the water cooling connection line is shorter than the length of directly connecting the first cooling plate to the N^{th} cooling plate and the length of directly connecting the N^{th} cooling plate to the second cooling plate, which may facilitate manufacturing.

On the other hand, if the first cooling plate is directly connected to the N^{th} cooling plate through the water cooling connection line, a voltage drop of cooling water flowing in the water cooling connection line is a sum of voltages of the N cooling plates. If the sum of the voltages of the N cooling plates is too large, an excessive power loss may be caused, thereby generating an excessive thermal loss, which is not conducive to heat dissipating. From this it follows that the greater the number of cooling plates spanned by the water cooling connection line, the greater the voltage drop of the cooling water located in the water cooling connection line, and thus the greater the thermal loss. Therefore, compared to directly connecting the first cooling plate to the N^{th} cooling plate and directly connecting the N^{th} cooling plate to the second cooling plate, when the first cooling plate is not directly connected to the N^{th} cooling plate and the N^{th} cooling plate is not directly connected to the second cooling plate, the number of cooling plates spanned by the water cooling connection line may be fewer, and the voltage drop of the cooling water flowing in each water cooling connection line may be smaller, thereby reducing the thermal loss.

Referring to FIG. 9, in some embodiments, the water cooling connection lines connect the first cooling plate and the m cooling plates successively according to a first connection rule that the water outlet 12 of the (1+a×p)^{th} cooling plate is connected to the water inlet 11 of the (1+(a+1)p)^{th} cooling plate, and the water outlet 12 of the (1+m×p)^{th} cooling plate is connected to the water inlet 11 of the N^{th} cooling plate, where a∈[0, m-1], p is an integer greater than 1, m≥1, and 1+ m×p< N.

That is to say, the water cooling connection lines may connect the cooling plates 10 according to a preset first connection rule. In this way, a connection of the water cooling connection lines may be more regular, which is beneficial to manufacturing of the heat dissipating device. Moreover, since the first connection rules of different cooling plates 10 are consistent, the numbers of cooling plates 10 spanned by the water cooling connection lines are consistent, so that voltage drops of cooling water in different water cooling connection lines are consistent, and the thermal losses generated by different water cooling connection lines spanning the cooling plates 10 are consistent, which is beneficial to balancing the heat dissipating.

The parameter a sequentially takes the values 0, 1, 2, ..., m-1, and p-1 may be used to represent the number of spanned cooling plates 10. In other words, the above-mentioned preset rule represents that: when connecting the cooling plate 10, the water cooling connection line bridges the water outlet 12 and the water inlet 11 of two cooling plates with p-1 cooling plates spaced therebetween.

For example, if a value of p is 2, and the water cooling connection lines connect the cooling plates 10 based on the above-mentioned first connection rule, the number of spanned cooling plates is 1, and a sequentially assumes the values 0, 1, 2, ..., m-1. The water outlet 12 of the first cooling plate is connected to the water inlet 11 of the third cooling plate, the water outlet 12 of the third cooling plate is connected to the water inlet 11 of the fifth cooling plate, and so on, until the water outlet 12 of an (1+(m-1)×p)^{th} cooling plate is connected to the water inlet 11 of the (1+m×p)^{th} cooling plate. The water outlet 12 of the (1+m×p)^{th} cooling plate is connected to the water inlet 11 of the N^{th} cooling plate.

It may be understood that the above-mentioned first connection rule may limit a selection of the m cooling plates. That is, the m cooling plates are the third cooling plate, ..., the (1+(m-1)×p)^{th} cooling plate and the (1+m×p)^{th} cooling plate in sequence. The k cooling plates 10 are the remaining cooling plates 10 other than the above selected m cooling plates, the first cooling plate, the second cooling plate and the N^{th} cooling plate.

It is readily apparent that since the first cooling plate, the second cooling plate and the N^{th} cooling plate are fixed, the remaining k cooling plates 10 are also fixed after the m cooling plates are connected according to the above-mentioned first connection rule. The water cooling connection lines only need to connect the N^{th} cooling plate, the k cooling plates 10 and the second cooling plate successively. In this way, the cooling plates 10 are connected according to the first connection rule, which may reduce a high-voltage hazard while ensuring that the cooling water cools the switch components located on the N cooling plates 10. Meanwhile, the thermal loss during the flow of the cooling water may be reduced.

It may be understood that the water cooling connection lines connect the m cooling plates according to the above-mentioned first connection rule until to the (1+m×p)^{th} cooling plate. That is, a connection of the cooling plates 10 between the (1+m×p)^{th} cooling plate and the N^{th} cooling plate is not limited by the above-mentioned first connection rule. A specific description will be provided below by taking N being 9 and m being 2 as an example.

Referring to FIG. 10, according to the above-mentioned first connection rule, the first cooling plate is connected to the third cooling plate, and the third cooling plate is connected to the fifth cooling plate. The cooling plates following the fifth cooling plate are not limited by the above-mentioned first connection rule, that is, the fifth cooling plate may be directly connected to the ninth cooling plate.

The more cooling plates 10 connected by the water cooling connection lines according to the above-mentioned rule, the more regular a connection of the cooling plates 10, and the more balanced a thermal loss caused by the cooling water flowing in different water cooling connection lines. In some embodiments, 1≤N-(1+m×p)≤p, where N represents a serial number of the N^{th} cooling plate, and 1+m×p represents a serial number of the (1+m×p)^{th} cooling plate. That is, the number of cooling plates 10 spaced between the N^{th} cooling plate and the (1+m×p)^{th} cooling plate is limited. In other words, the value of m may be limited, so that the number of cooling plates 10 connected according to the above-mentioned first connection rule may be limited.

For example, if a value of N-(1+m×p) is 1, it means that the number of cooling plates 10 spaced between the N^{th} cooling plate and the (1+m×p)^{th} cooling plate is 0. If the value of N-(1+m×p) is p, it means that the number of cooling plates 10 spaced between the N^{th} cooling plate and the (1+m×p) cooling plate is p-1.

1≤N-(1+m×p)≤p represents that the number of cooling plates 10 spaced between the N^{th} cooling plate and the (1+m×p)^{th} cooling plate is between 0 and p-1. The water cooling connection lines may connect the cooling plates 10 between the first cooling plate and the N^{th} cooling plate to a maximum extent according to the above-mentioned first connection rule. A specific description will be provided below by taking N being 9 and p being 2 as an example.

Referring to FIG. 11, 1≤9-(1+m×2)≤2. It may thus be concluded that 3≤m≤ 3.5, that is, the value of m is limited to 3. According to the above-mentioned first connection rule, the m cooling plates are the third cooling plate, the fifth cooling plate and the seventh cooling plate in sequence. The seventh cooling plate is exactly the last one of cooling plates between the first cooling plate and the N^{th} cooling plate that satisfies the above-mentioned first connection rule. Therefore, by limiting the value of m using the above-mentioned equation, all the cooling plates 10 connected between the first cooling plate and the N^{th} cooling plate that satisfy the above-mentioned first connection rule may be selected and connected.

In some embodiments, 2≤p≤4. When p is equal to 2, the number of cooling plates 10 spanned by the water cooling connection line may be one, that is, the first cooling plate is connected to the third cooling plate, the third cooling plate is connected to the fifth cooling plate, and so on. When p is equal to 3, the number of cooling plates 10 spanned by the water cooling connection line may be two, that is, the first cooling plate is connected to the fourth cooling plate, the fourth cooling plate is connected to the seventh cooling plate, and so on. When p is equal to 4, the number of cooling plates 10 spanned by the water cooling connection line may be three, that is, the first cooling plate is connected to the fifth cooling plate, the fifth cooling plate is connected to the ninth cooling plate, and so on. Within the above-mentioned range, the number of cooling plates 10 spanned by the water cooling connection line is not too much, so that the voltage drop generated by the cooling water in the water cooling connection line is not too large, which may ensure that the thermal loss is not too large, so as to facilitate heat dissipating.

Referring to FIG. 12 and FIG. 13, in some embodiments, the value of p is 2. That is to say, the number of cooling plates spanned by the water cooling connection line is one. In this way, the water cooling connection lines connect cooling plates at an interval of one cooling plate, and lengths of the water cooling connection lines connecting different cooling plates 10 are substantially the same. Moreover, when the first cooling plate and the m cooling plates are connected to the N^{th} cooling plate in a way of spanning one cooling plate, in the remaining k cooling plates 10, the number of cooling plates 10 spaced between two successively connected cooling plates is also 1, so that when the k cooling plates 10 are connected, the water cooling connection lines also span one cooling plate for connection. Thereby, the length of the water cooling connection line connecting the m cooling plates 10 is the same as the length of the water cooling connection line connecting the k cooling plates 10, which may realize a minimum thermal loss in a case of the generated thermal losses being the same.

A specific description will be provided below by taking N being 9, n being 2 and m being 3 as an example.

When n is 9 and m is 3, k equals 3. The m cooling plates are the third cooling plate, the fifth cooling plate and the seventh cooling plate in sequence. The k cooling plates 10 are the eighth cooling plate, the sixth cooling plate and the fourth cooling plate in sequence.

The first cooling plate is connected to the third cooling plate, the third cooling plate is connected to the fifth cooling plate, the fifth cooling plate is connected to the seventh cooling plate, and the seventh cooling plate is connected to the ninth cooling plate.

During backflow, the ninth cooling plate is connected to the eighth cooling plate, the eighth cooling plate is connected to the sixth cooling plate, the sixth cooling plate is connected to the fourth cooling plate, and the fourth cooling plate is connected to the second cooling plate. It may be found that, any two adjacent cooling plates 10 belonging to the m cooling plates are spaced by a cooling plate belonging to one of the k cooling plates 10. In this way, when connecting the m cooling plates and the k cooling plates 10, the water cooling connection lines span one cooling plate for connection.

Referring to FIG. 12, in some embodiments, the value of p is 2, N is an odd number, and N-(1+m×p)=2. That is to say, for an odd number of N, the N^{th} cooling plate and the (1+m×p)^{th} cooling plate are spaced by one cooling plate. In this way, a maximum value of m that satisfies the above-mentioned first connection rule when N is an odd number may be limited. That is, the (1+m×p)^{th} cooling plate is the (N-2)^{th} cooling plate.

It should be noted that when N is an odd number, when the first to the N^{th} cooling plates are connected, two cooling plates spaced by one cooling plate are connected by the water cooling connection line according to the first connection rule of spanning one cooling plate.

During backflow, the N^{th} cooling plate is connected to the (N-1)^{th} cooling plate, that is, no bridging is provided between the N^{th} cooling plate and the (N-1)^{th} cooling plate. After that, when the k cooling plates 10 are connected, the k cooling plates 10 are connected successively by the water cooling connection lines according to a second connection rule of spanning one cooling plate.

Referring to FIG. 13, in some embodiments, the value of p is 2, N is an even number, and N-(1+m×p)=1. That is to say, for an even number of N, 0 cooling plate is between the N^{th} cooling plate and the (1+m×p)^{th} cooling plate. In this way, the maximum value of m that satisfies the above-mentioned first connection rule when N is an even number may be limited. That is, the (1+m×p)^{th} cooling plate is the (N-1)^{th} cooling plate.

It should be noted that when N is an even number, when connecting the first cooling plate and the m cooling plates, two cooling plates spaced by one cooling plate spaced are connected by the water cooling connection line according to the first connection rule of spanning one cooling plate. When the m cooling plates have been connected, the (N-1)^{th} cooling plate is connected to the N^{th} cooling plate, that is, no cooling plate 10 is spanned between the last cooling plate of the m cooling plates and the N^{th} cooling plate.

During backflow, the cooling plates from the N^{th} cooling plate to the second cooling plate are connected successively according to the second connection rule of spanning one cooling plate.

Referring to FIG. 14, in some embodiments, the water cooling connection lines connect the N^{th} cooling plate and the k cooling plates 10 successively according to a second connection rule that, the water outlet 12 of the (N-b×q)^{th} cooling plate is connected to the water inlet 11 of the (N-(b+1)×q)^{th} cooling plate, and the water outlet 12 of the (N-k×q)^{th} cooling plate is connected to the water inlet 11 of the second cooling plate, where b∈[0,k-1], q is an integer greater than 1, k≥1, and N-k×q>2.

The second connection rule is used to constrain how the k cooling plates 10 are selected. The water cooling connection lines may connect the cooling plates 10 according to the second connection rule, so that the connection of the water cooling connection lines may be more regular.

The parameter b sequentially takes the values 0, 1, 2, ..., k-1, and q-1 may be used to represent the number of spanned cooling plates 10. In other words, the above-mentioned preset rule represents that when connecting the cooling plates 10, the water cooling connection lines connect the water outlet 12 and the water inlet 11 of two cooling plates spaced by q-1 cooling plates.

For example, if the value of q is 2, when the water cooling connection lines connect the cooling plates 10 based on the above-mentioned second connection rule, the number of spanned cooling plates is 1, and b sequentially takes the values 0, 1, 2, ..., k-1. The water outlet 12 of the N^{th} cooling plate is connected to the water inlet 11 of the (N-2)^{th} cooling plate, the water outlet 12 of the (N-2)^{th} cooling plate is connected to the water inlet 11 of the (N-4)^{th} cooling plate, and so on, until the water outlet 12 of the (N-(k-1)×q)^{th} cooling plate is connected to the water inlet 11 of the (N-k×q)^{th} cooling plate. The water outlet 12 of the (N-k×q)^{th} cooling plate is connected to the water inlet 11 of the second cooling plate.

It may be understood that the second connection rule limits the selection of the k cooling plates 10. Among the N cooling plates 10, the remaining cooling plates 10 belong to the m cooling plates other than the first cooling plate, the second cooling plate, the N^{th} cooling plate 10 and the k cooling plates 10. The water cooling connection lines only need to connect the first cooling plate, the m cooling plates and the N^{th} cooling plate successively.

In some embodiments, 1≤(n-k×q)-2≤q, where N-k×q represents a serial number of the (N-k×q)^{th} cooling plate. That is to say, the number of cooling plates 10 between the (N-k×q)^{th} cooling plate and the second cooling plate is limited. In other words, the value of k may be limited, so that the number of cooling plates 10 connected according to the above-mentioned second connection rule may be limited, so as to maximize the value of k.

For example, if a value of (N-k×q)-2 is 1, it means that the number of cooling plates 10 between the (N-k×q)^{th} cooling plate and the second cooling plate is 0. If the value of (N-k×q)-2 is q, it means that the number of cooling plates 10 between the (N-k×q)^{th} cooling plate and the second cooling plate is q-1.

1≤(N-k×q)-2≤q represents that the number of cooling plates 10 between the (N-k×q)^{th} cooling plate and the second cooling plate is between 0 and q-1. The water cooling connection lines may connect the cooling plates 10 between the N^{th} cooling plate and the second cooling plate to a maximum extent according to the second connection rule.

A specific description will be provided below by taking N being 9 and q being 2 as an example.

1≤(9-k×2)-2≤2. It may thus be concluded that 2.5≤k≤3, that is, the value of k is limited to 3. According to the above-mentioned second connection rule, the k cooling plates 10 are the seventh cooling plate, the fifth cooling plate and the third cooling plate in sequence. The third cooling plate is exactly the last one of cooling plates between the N^{th} cooling plate and the second cooling plate that satisfies the second connection rule. Therefore, by limiting the value of k by the above-mentioned equation, all the cooling plates 10 between the N^{th} cooling plate and the second cooling plate that satisfy the above-mentioned second connection rule may be selected and connected.

In some embodiments, 2≤q≤4. When q is equal to 2, the number of cooling plates 10 spanned by the water cooling connection line may be one. When q is equal to 3, the number of cooling plates 10 spanned by the water cooling connection line may be two. When q is equal to 4, the number of cooling plates 10 spanned by the water cooling connection line may be three. Within the above-mentioned range, the number of cooling plates 10 spanned by the water cooling connection line is not too large, so that the voltage drop generated by the cooling water in the water cooling connection line is not too large, which may ensure that the thermal loss is not too large, so as to facilitate heat dissipating.

It should be noted that in some embodiments, selections of the m cooling plates and the k cooling plates 10 are not limited to the first connection rule and the second connection rule, and other methods may be used for connection.

For example, when the first cooling plate and the m cooling plates are connected, the numbers of cooling plates 10 spanned by the water cooling connection lines may be different, which may be 0, 1, 2 or other numbers.

Referring to FIG. 15, taking N being 9 as an example, the water cooling connection line may connect the water outlet 12 of the first cooling plate to the water inlet 11 of the third cooling plate 10, connect the water outlet 12 of the third cooling plate to the water inlet 11 of the fourth cooling plate, connect the water outlet 12 of the fourth cooling plate to the water inlet 11 of the sixth cooling plate, and connect the water outlet 12 of the sixth cooling plate to the water inlet 11 of the eighth cooling plate. That is to say, the m cooling plates are the third cooling plate, the fourth cooling plate, the sixth cooling plate and the eighth cooling plate, respectively. The k cooling plates 10 are the seventh cooling plate and the fifth cooling plate, respectively. The water cooling connection line may connect the water outlet 12 of the ninth cooling plate to the water inlet 11 of the seventh cooling plate, connect the water outlet 12 of the seventh cooling plate 10 to the water inlet 11 of the fifth cooling plate, and connect the water outlet 12 of the fifth cooling plate to the water inlet 11 of the second cooling plate.

From the above-mentioned examples, it may be seen that the water cooling connection lines may also connect the water outlets 12 and the water inlets 11 of different cooling plates 10 by other methods, so as to allow the cooling water to flow across the cooling plates 10.

In the heat dissipating device for a Marx generator provided in the above-mentioned embodiments, after flowing out of the first cooling plate 10, the cooling water flows through the m cooling plates in sequence to the N^{th} cooling plate. The cooling water finally flows back to the second cooling plate to flow out after flowing through the k cooling plates 10 in sequence. The backflow process may cancel out most of the voltage difference of N units generated by the cooling water flowing through the first cooling plate and the m cooling plates to the N cooling plates 10, so that the final voltage of the cooling water is only the voltage difference between the water outlet of the second cooling plate and the water inlet of the first cooling plate, that is, only two voltage differences, which may greatly reduce the voltage of the cooling water.

According to a second aspect of the present disclosure, a Marx generator is further provided, including the heat dissipating device for a Marx generator provided in the above-mentioned embodiments. The Marx generator may include: a DC charging power supply and a plurality of switch components connected in series. The DC charging power supply is a power supply, and each switch component is used to generate a high-voltage pulse circuit by charging and discharging. The number of switch components may be set according to a required pulse voltage. The switch component in the Marx generator is fixed on the cooling plate 10 in the heat dissipating device.

The embodiments of the present disclosure have been described above. However, the embodiments are for illustrative purposes only, and are not intended to limit the scope of the present disclosure. Although the embodiments are described above separately, this does not mean that the measures in the embodiments may not be advantageously used in combination. The scope of the present disclosure is defined by the appended claims and their equivalents. Without departing from the scope of the present disclosure, those skilled in the art may make various substitutions and modifications, and these substitutions and modifications should all fall within the scope of the present disclosure.

## Claims

1. A heat dissipating device for a Marx generator, the device comprising:
N cooling plates arranged in sequence, wherein a switch component of the Marx generator is fixed on each of the N cooling plate, and the switch components on the N cooling plates are connected in series in sequence; each of the N cooling plates is provided with a water inlet and a water outlet, cooling water flows from the water inlet into an interior of the cooling plate and flows out of the water outlet, and the water inlets and the water outlets of different cooling plates are connected by water cooling connection lines to allow the cooling water to flow across the cooling plates,
wherein the cooling water flows in through the water inlet of a first cooling plate and flows out of the water outlet of the first cooling plate, after sequentially flowing through m cooling plates other than a second cooling plate, the cooling water flows into the water inlet of an N^{th} cooling plate and flows out of the water outlet of the N^{th} cooling plate, after sequentially flowing through k cooling plates, the cooling water flows out of the water outlet of the second cooling plate, wherein m+k=N-3, 0≤m≤N-3, and 0≤k≤N-3, and the m cooling plates are different from the k cooling plates.

2. The heat dissipating device for a Marx generator according to claim 1, wherein the water cooling connection lines connect the first cooling plate and the m cooling plates successively according to a first connection rule that the water inlet of a (1+a×p)^{th} cooling plate is connected to the water outlet of a (1+(a+1)p)^{th} cooling plate, and the water outlet of a (1+m×p)^{th} cooling plate is connected to the water inlet of the N^{th} cooling plate, wherein a∈[0, m-1], p is an integer greater than 1, m≥1, and 1+m×p<N.

3. The heat dissipating device for a Marx generator according to claim 2, wherein 1 ≤N-(1+m×p)≤p.

4. The heat dissipating device for a Marx generator according to claim 3, wherein 2 ≤p≤4.

5. The heat dissipating device for a Marx generator according to claim 4, wherein a value of p is 2.

6. The heat dissipating device for a Marx generator according to claim 5, wherein N is an odd number, and N-(1+m×p)=2.

7. The heat dissipating device for a Marx generator according to claim 5, wherein N is an even number, and N-(1+m×p)=1.

8. The heat dissipating device for a Marx generator according to claim 1, wherein the water cooling connection lines connect the N^{th} cooling plate and the k cooling plates successively according to a second connection rule that, the water outlet of an (N-b×q)^{th} cooling plate is connected to the water inlet of an (N-(b+1)×q)^{th} cooling plate, and the water outlet of an (N-k× q)^{th} cooling plate is connected to the water inlet of the second cooling plate, wherein b∈[0,k-1], q is an integer greater than 1, k≥1, and N-k×q>2.

9. The heat dissipating device for a Marx generator according to claim 1, wherein 1 ≤(N-k×q)-2≤q.

10. The heat dissipating device for a Marx generator according to claim 1, wherein 2 ≤q≤4.

11. The heat dissipating device for a Marx generator according to any one of claims 1 to 10, wherein each of the N cooling plates comprises a first surface and a second surface opposite each other, and the switch component is located on the first surface and is in metallic contact with the first surface.

12. The heat dissipating device for a Marx generator according to claim 11, wherein the N cooling plates are arranged in sequence in a first direction, the water inlet and the water outlet are disposed on a side surface of each of the N cooling plates, and the water inlets and the water outlets corresponding to the N cooling plates are alternately arranged in the first direction.

13. The heat dissipating device for a Marx generator according to claim 11, wherein the switch component of the Marx generator comprises:
an IGBT;
a Zener diode, wherein an input end of the Zener diode is electrically connected to a first end of the IGBT;
a capacitor connected in series between a second end of the IGBT and an output end of the Zener diode; and
an input diode electrically connected to the first end of the IGBT.

14. A Marx generator, comprising the heat dissipating device according to any one of the preceding claims.
